(19) Europäisches Patentamt
European Patent Office
Office européen des brevets

(11) **EP 2 598 908 B1**

(12) **EUROPÄISCHE PATENTSCHRIFT**

(45) Veröffentlichungstag und Bekanntmachung des Hinweises auf die Patenterteilung:
**23.11.2016 Patentblatt 2016/47**

(21) Anmeldenummer: **11737961.0**

(22) Anmeldetag: **28.07.2011**

(51) Int Cl.:
*G01S 7/481* (2006.01)     *G01S 7/497* (2006.01)
*H05B 33/08* (2006.01)     *H05B 37/02* (2006.01)
*G01S 17/02* (2006.01)     *H03K 17/78* (2006.01)

(86) Internationale Anmeldenummer:
**PCT/EP2011/063040**

(87) Internationale Veröffentlichungsnummer:
**WO 2012/013757 (02.02.2012 Gazette 2012/05)**

(54) **OPTO-ELEKTRONISCHE MESSANORDNUNG MIT ELEKTRO-OPTISCHER GRUNDKOPPLUNG**

OPTO-ELECTRONIC MEASURING ARRANGEMENT WITH ELECTRO-OPTICAL BASIC COUPLING

DISPOSITIF DE MESURE OPTOÉLECTRONIQUE COMPORTANT UN COUPLAGE DE BASE ÉLECTRO-OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.12.2010 EP 10196902**
**30.07.2010 EP 10171461**

(43) Veröffentlichungstag der Anmeldung:
**05.06.2013 Patentblatt 2013/23**

(73) Patentinhaber: **Mechaless Systems GmbH**
**76646 Bruchsal (DE)**

(72) Erfinder: **SCHWENINGER, Erhard**
**76149 Karlsruhe (DE)**

(74) Vertreter: **Durm & Partner**
**Patentanwälte**
**Moltkestrasse 45**
**76133 Karlsruhe (DE)**

(56) Entgegenhaltungen:
**EP-B1- 1 671 160     DE-A1- 10 001 955**
**US-A- 5 666 037**

EP 2 598 908 B1

**Beschreibung**

Die vorliegende Erfindung betrifft eine opto-elektronische Messanordnung mit den Merkmalen des Oberbegriffs des Anspruchs 1.

Eine derartige opto-elektronische Messanordnung arbeitet nach dem HALIOS®-Prinzip der ELMOS AG mit (rein) optischer Sender-Grundkopplung. Dieses im Stand der Technik bekannte Messprinzip ist unter anderem in folgenden Dokumenten beschrieben: US 5,666,037; EP 0 706 648 B1; EP 1 671 160 B1; DE 100 01 955 A1.

Die Messanordnung, im Folgenden "Sensor" genannt, umfasst neben einer Sendelichtquelle, im Folgenden "Sender" genannt auch eine Kompensationslichtquelle, im Folgenden "Kompensator" genannt, wobei beide Lichtquellen abwechselnd von je einem Stromtreiber bestromt in der Sendephase bzw. Kompensationsphase Licht (i. d. R. im IR-Spektrum) aussenden. Hierfür steuert ein Taktgenerator die Stromtreiber mit um 180° gegeneinander phasenversetzten Taktsignalen an. Die Frequenz kann im Bereich von einigen bis zu mehreren hundert kHz liegen.

Ein optischer Empfänger empfängt mit einer Photodiode einen Teil des von den beiden Lichtquellen ausgesendeten Lichts und wandelt dieses in Strom-Wechselsignale um, die - nach der Trennung von Gleichstrom- und niederfrequenten Signal-Anteilen (herrührend im Allgemeinen vom Umgebungslicht) - durch eine Hochpassfunktion (z.B. Kondensator) auf einen Transimpedanzverstärker (TIA) geführt werden, der diese Stromsignale in Spannungen umwandelt. Diese Spannungen wiederum werden in einem synchronen Demodulator wieder abwechselnd der Sende- und Kompensationsphase zugeordnet und auf einen Regler geführt, der die Aufgabe hat, diese beiden Signalanteile in der Amplitude gleich zu machen. Dafür regelt der Regler die Amplituden der Ströme durch den Kompensator und Sender entsprechend. Es kann - je nach Anwendung - bei konstanter Sender-Stromamplitude nur die Amplitude des Kompensator-Stromes geregelt werden, oder umgekehrt, bei konstanter Kompensator-Stromamplitude nur die Amplitude des Sender-Stromes. Die Amplituden des Kompensatorstroms liegen i. d. R. im Bereich von einigen, wenigen mA. Die Sender-Stromamplituden können - je nach Anwendung - im Bereich von einigen mA bis mehreren hundert mA liegen.

Das vom Sender in die Umgebung des Sensors abgestrahlte Licht trifft außerhalb des Sensors auf das zu messende (zu detektierende) Objekt, welches einen Teil des auftreffenden Lichts zurück zur Photodiode des Sensors reflektiert. Das Verhältnis gebildet aus dem empfangenen Strom in der Photodiode und dem dafür eingesetzten Senderstrom ist der optische Kopplungsfaktor der Sender-Messobjekt-Photodiode-Strecke, den der Sensor ermittelt und in seinem Regler-Stellsignal abbildet.

Ein weiterer (i. d. R. kleinerer) Lichtanteil des Senderlichts gelangt innerhalb des Sensors, und damit unabhängig vom Messobjekt, ebenfalls zur Photodiode. Dies ist der Anteil der dem (inneren) optischen Kopplungsfaktor der Sender-Photodiode-Strecke (im Folgenden "optische Grundkopplung", "OGK") entspricht. Es handelt sich dabei um einen (rein) optischen Kopplungsfaktor, da er ausschließlich von geometrischen Parametern (Abständen, Winkeln) und Materialeigenschaften des optischen Pfades (Reflektion oder Dämpfung) im Inneren des Sensors abhängt. Mathematisch betrachtet ist die optische Grundkopplung das Verhältnis, gebildet aus dem vom Senderlicht in der Photodiode ohne Messobjekt generierten Stromes und dem dafür eingesetzten Senderstrom. Es wird also nur der Anteil des Senderlichts betrachtet, der über den im Sensor liegenden Lichtpfad zur Photodiode übertragen wird.

Die optische Grundkopplung ist konstant und wird in den meisten Fällen von der Sensorabdeckung maßgeblich mitbestimmt. Wenn z.B. bei einer LED als Sender ein LED-Senderstrom von 50mA einen Photodiodenstrom von 50nA erzeugt, so beträgt die optische Grundkopplung OGK in diesem Fall 1:1000000 oder anders ausgedrückt $1 \times 10^{-6}$.

Der Kompensator ist so realisiert, dass das von ihm abgestrahlte Licht das Messobjekt (praktisch) nicht erreichen kann, sondern im Inneren des Sensors zur Photodiode geleitet wird. In der praktischen Umsetzung wird der vom Kompensator abgestrahlte Lichtanteil auf ein vordefiniertes Maß eingestellt, so dass lediglich ein gewisser (i. d. R. kleiner) Teil des abgestrahlten Lichts während der Kompensationsphase auf die Photodiode des Sensors trifft. Das Verhältnis, von dem aus diesem Lichtanteil in der Photodiode generierten Strom zu dem dafür eingesetzten Kompensationsstrom, ist der optische Kopplungsfaktor der Kompensator-Photodiode-Strecke. Er ist konstant. Da das vom Kompensator abgestrahlte Licht im Wesentlichen nicht zum Messobjekt gelangt, stellt es somit eine unveränderliche Größe oder Referenz für die Messung dar. Wenn z.B. bei einer LED als Kompensator ein LED-Kompensatorstrom von 1mA einen Photodiodenstrom von 50nA erzeugt, so beträgt die Kompensatorkopplung in diesem Fall 1:20000 oder anders ausgedrückt $50 \times 10^{-6}$.

Da sowohl das vom Sender als auch das vom Kompensator stammende Licht den gesamten Empfängerpfad einschließlich der Photodiode passiert, werden beide Signalanteile in gleichem Maße von der Übertragungscharakteristik des gesamten Empfängerpfades beeinflusst. Der Empfängerpfad schließt neben der Photodiode auch den Hochpass und den Transimpedanzverstärker ein.

Mathematisch betrachtet, fällt die Übertragungsfunktion des gesamten Empfängers sogar aus den Systemgleichungen heraus und mit ihr auch sämtliche relevanten störenden Abhängigkeiten wie z.B. die Lichtempfindlichkeit oder Temperaturabhängigkeit der Photodiode. Hiermit erklärt sich unter anderem die hohe Fremdlichtunabhängigkeit der HALIOS®-Messmethode. Selbst unter vollem Sonnenlicht (100klx) bleibt der Sensor funktionsfähig. Er ist auch unter diesen verschärften Umgebungslichtbedingungen geeignet, ein Objekt innerhalb seines definierten Messbereiches sicher zu erkennen. Ebenso können Bewegungen dieses Objekts erkannt werden. So ist es z.B. möglich die Annäherung einer Hand oder deren Wischbewegung in verschiedene Richtungen zu unterscheiden. Auch die Berührungen des Sensors durch einen Finger (Tippen) können als Schaltfunktionen interpretiert werden. Mit einer leistungsfähigen Optik ausgestattet kann ein nach dem HALIOS®-Prinzip arbeitender Sensor aber auch in größerer Entfernung, beispielsweise in 5m oder 10m Entfernung ein Objekt, z.B. ein Gepäckstück auf einem Förderband erkennen.

Die optische Sender-Grundkopplung (OGK) bestimmt den sogenannten Regler-Ruhewert der gesamten Messanordnung. Ist kein Messobjekt in der Nähe des Sensors vorhanden, so wird auch kein Licht während der Sendephase von außerhalb des Sensors zur Photodiode reflektiert. Das Sensorsystem wird lediglich auf die optische Grundkopplung (OGK) ausgeregelt. Sie beeinflusst maßgeblich eine ganze Reihe von Eigenschaften des Sensors: So z.B. bestimmt die optische Grundkopplung die Empfindlichkeit des Sensors. Ist die optische Grundkopplung des Sensors hoch, wird nur ein relativ kleiner Teil des vom Sender abgestrahlten Lichts vom Messobjekt verändert. Die SensorEmpfindlichkeit ist demnach entsprechend gering. Dies ist gleichbedeutend mit einem geringen Messbereich des Sensors. Umgekehrt bedeutet eine kleine optische Grundkopplung eine große Sensorempfindlichkeit, was wiederum den Messbereich des Sensors vergrößert. Gleichzeitig bedeutet eine geringe optische Grundkopplung aber auch, dass der Ruhewert stärker verrauscht ist, da das Sensorsystem mit wenig, oder weniger Energie auskommen muss, da die energiereiche Signalkomponente vom (fehlenden) Messobjekt in diesem Arbeitspunkt gänzlich fehlt. Verrauschte Signale verlangsamen den Regelprozess, was wiederum eine reduzierte Reaktionsgeschwindigkeit des Sensors bei einem sich entfernenden Messobjekt nach sich zieht.

Die optische Grundkopplung ist also eine wichtige Größe in jedem Sensor, der nach dem HALIOS®-Prinzip arbeitet, und muss demnach genau abgestimmt werden. Bei den bekannten Messanordnungen im Stand der Technik erfolgt die Einstellung der optischen Grundkopplung ausschließlich über konstruktive Maßnahmen und Änderungen des Sensors. Die Einstellung des Sensors ist deshalb sehr aufwändig und kann nur für einen festen Wert vorgenommen werden. Insbesondere bei Messanordnungen (Sensoren) mit mehreren Sendern, die zur Photodiode unterschiedlich weit entfernt angeordnet sind, wird für jeden Sender eine definierte, eigene optische Grundkopplung zur Photodiode benötigt. Die dafür zu lösende opto-mechanische Aufgabe ist i. d. R. sehr aufwändig und macht die Herstellung und vor allem das Sensordesign teuer.

Aus dem vorliegenden Stand der Technik ergibt sich also die Aufgabe, eine verbesserte opto-elektronische Messanordnung zu schaffen. Sie soll insbesondere die Möglichkeit einer vereinfachten und optimierten Einstellung der optischen Grundkopplung bieten.

Gelöst wird die vorliegende Aufgabe durch eine opto-elektronische Messanordnung mit den Merkmalen des Anspruchs 1.

Die erfindungsgemäße opto-elektronische Messanordnung dient insbesondere der Erfassung der Position und/oder Bewegung eines Objekts. Die Messanordnung umfasst eine Sendelichtquelle und eine Kompensationslichtquelle, die je Licht zeitsequentiell getaktet, phasenweise aussenden. Das jeweils ausgesendete Licht der Lichtquellen ist phasenverschoben zueinander. Die Messanordnung umfasst einen optischen Empfänger mit einer Photodiode zum Empfangen von Licht, das ein von den Lichtquellen ausgesendetes taktsynchrones Messsignal umfasst. Der optische Empfänger hat auch eine Verstärkereinheit zum Verstärken eines auf dem empfangenen Messsignal beruhenden und in der Photodiode generierten Stroms. Ein Taktgenerator erzeugt ein Taktsignal, mit dem eine steuerbare Stromquelle zur Erzeugung eines getakteten Sendesteuerstroms für die Sendelichtquelle und mit dem eine steuerbare Kompensationsstromquelle zur Erzeugung eines getakteten Kompensationssteuerstroms für die Kompensationslichtquelle gespeist werden, wobei der Kompensationsstromquelle das invertierte Taktsignal zugeführt wird. Der Demodulator der Messanordnung wird zur taktsynchronen Auswertung des Messsignalstroms, der mit der Photodiode empfangen und mit dem Transimpedanzverstärker in ein entsprechendes Spannungssignal umgewandelt bzw. verstärkt wird, verwendet.

Die Reglereinheit erzeugt wenigstens ein Ansteuersignal für die steuerbare Stromquelle und/oder Kompensationsstromquelle. Sie ist derart eingerichtet und ausgebildet, dass die Kompensationslichtquelle und/oder die Sendelichtquelle durch Steuerung des entsprechenden Steuerstroms (Kompensationssteuerstrom bzw. Sendesteuerstrom) in ihrer Lichtintensität in der Amplitude derart regelbar ist, dass die zwischen verschiedenen Phasen auftretende taktsynchrone Signaldifferenz zu Null ausgeregelt wird.

Erfindungsgemäß umfasst die opto-elektronische Messanordnung zusätzlich eine weitere Stromquelle (im Allgemeinen sogar für jeden einzelnen Sender im Sensor), im Folgenden "Grundkopplungsstromquelle" genannt, die takt- und phasensynchron zum Sender-Stromtreiber arbeitet, d. h. genau dann, wenn der Sender-Stromtreiber seinen Impuls erzeugt, erzeugt auch die Grundkopplungsstromquelle ihren Stromimpuls. Die steuerbare Grundkopplungsstromquelle erzeugt also einen getakteten Grundkopplungssteuerstrom. Die Grundkopplungsstromquelle wird ebenfalls mit dem Taktsignal des Taktgenerators getaktet, und zwar mit dem gleichen Takt wie die Sendelichtquelle.

Der Grundkopplungssteuerstrom wird bevorzugt in einer ersten Realisierungsvariante durch eine eigens dafür vorgesehene Lichtquelle (Grundkopplungslichtquelle) geleitet, die ausschließlich im Inneren des Sensors die geeignete Lichtmenge zur Photodiode abstrahlt. Die Grundkopplungslichtquelle hat keinen Lichtanteil, der die Messanordnung verlässt und in den Außenraum (außerhalb der Messanordnung) gelangt. Das Messobjekt wird also von der Grundkopplungslichtquelle nicht angestrahlt.

Damit übernimmt die Grundkopplungslichtquelle ganz oder auch nur teilweise die Erzeugung der notwendigen optischen Grundkopplung OGK einer im Stand der Technik bekannten Messanordnung. Die großen Vorteile dabei sind, dass diese Lichtquelle weitgehend frei (d.h. unabhängig vom Sender) positioniert werden kann, dass Sie die Möglichkeit einer eigenen, individuell einstellbaren optische Kopplung zur Photodiode bietet und in der Stromstärke individuell (leicht und schnell) eingestellt und insbesondere in einer bevorzugten IC-Realisierung bei Bedarf sogar beliebig umkonfiguriert werden kann. Letzteres geschieht also ausschließlich mit elektronischen Mitteln. Damit ist die Möglichkeit einer elektronisch einstellbaren optischen Grundkopplung (im Folgenden kurz "EOGK" genannt) geschaffen.

Der Grundkopplungssteuerstrom wird derart eingestellt, dass eine gewünschte Empfindlichkeit der Messanordnung erzielt wird, was über die Einstellung des Ruhewertes maßgeblich mitbestimmt wird. Daneben lässt sich optional oder zusätzlich die Stabilität der Regelung und die Dynamik (Aussteuerbereich und dynamisches Verhalten) der Reglereinheit gezielt beeinflussen. Dazu werden ohne Anwesenheit eines zu erfassenden Objekts die Sendelichtquelle und/oder die Kompensationslichtquelle mittels der Regeleinheit derart geregelt, dass das empfangene Messsignal, das von der Grundkopplungslichtquelle ausgesendet wird, durch das Kompensatorsignal ausgeregelt wird. Die Regelung erfolgt so, dass die phasenverschobenen Signale, die am optischen Empfänger in den beiden Messphasen abwechselnd gemessen werden, in jedem ausgeregelten Arbeitspunkt gleich sind. Bevorzugt wird die Grundkopplungslichtquelle also so geregelt, dass der für die vorgesehene Anwendung der Messanordnung gewünschte oder erforderliche Ruhewert eingestellt werden kann. Der Grundkopplungssteuerstrom dient also zur Festlegung dieses wichtigen Arbeitspunktes.

Die Grundkopplung ist definiert als der von der (Messsignal-)Lichtquelle ohne Reflexion an einem zu erfassenden Objekt reflektierte Anteil des von der Sender-Lichtquelle ausgestrahlten Lichts. Die Grundkopplung ist der Lichtanteil der Lichtquelle, der ausschließlich innerhalb der Messanordnung zur Photodiode transportiert bzw. geleitet oder gestrahlt wird (mit oder ohne Reflexion innerhalb der Messanordnung).

Die gewünschte oder notwendige optische Grundkopplung wird im Stand der Technik i. d. R. durch optomechanische konstruktive Maßnahmen eingestellt. Dies ist insbesondere bei mehreren Sendelichtquellen in dem Sensor (Messanordnung) oft sehr aufwändig. Verschmutzungen, Feuchtigkeit oder Kratzer an der Sensoroberfläche können die optische Grundkopplung zudem empfindlich verändern.

Bei der Erfindung wurde die Erkenntnis genutzt, dass eine optische Kopplung zwischen der Sendelichtquelle und der Photodiode besteht, die sich aus zwei Anteilen zusammensetzt. Der erste Anteil der optischen Kopplung ist der funktionale, von der Messanordnung zu bestimmende Objektkopplungsanteil. Dieser Anteil stellt also den außerhalb der Messanordnung durch das Messobjekt reflektierten Lichtanteil dar. Ist kein Objekt in der Nähe der Messanordnung vorhanden, ist dieser von der Photodiode empfangene Lichtanteil gleich Null. Der zweite Anteil der optischen Kopplung ist die sogenannte optische Grundkopplung des Senders. Dieser Anteil beruht auf der Beleuchtung der Photodiode, über den optischen Pfad zwischen dem Sender und der Photodiode ausschließlich innerhalb des Sensors. Die Grundkopplung muss genau definiert werden, denn sie hat für die optische Messanordnung mehrfache Auswirkungen. Zum einen ist die Grundkopplung der Senderlichtquelle genau die Messgröße, mit welcher die Reglereinheit arbeitet, solange kein Messobjekt vorhanden ist. Die Grundkopplung bestimmt deshalb insbesondere den Ruhewert der Messanordnung.

Zudem wird durch Einstellen der Grundkopplung die Empfindlichkeit der Messanordnung und somit die Reichweite des Sensors beeinflusst. Durch Einstellung der Empfindlichkeit bzw. durch Änderung der Grundkopplung kann bestimmt werden, in welcher Entfernung von der Messanordnung ein Objekt noch erkannt werden kann.

Ein weiterer Einfluss der Grundkopplung auf die Messanordnung ist die durch die Grundkopplung mitbestimmte Rauschleistung in der Messanordnung und die damit verbundene Einschwingzeit des Sensorsignals. Somit hat die Grundkopplung also Einfluss auf die Geschwindigkeit, mit der Messobjekte erkannt werden können.

Im Rahmen der Erfindung wurde erkannt, dass sich aus der Tatsache, dass die optische Grundkopplung der Messanordnung in vielen Anwendungsfällen gering oder zu gering ist, oder auch gezielt stark reduziert werden kann, so dass sie bevorzugt nahezu vernachlässigbar ist, die Möglichkeit eröffnet, den notwendigen bzw. fehlenden Kopplungswert elektro-optisch zu generieren. Bevorzugt wird die Grundkopplungslichtquelle durch mechano-optische Maßnahmen grob abgeschirmt, so dass das ausgesendete Licht in geeigneter Intensität zur Photodiode gelangen kann. Die Einstellung erfolgt ohne einen von einem Messobjekt reflektierten Lichtanteil. Durch eine geeignete (elektronische) Ansteuerung der Grundkopplungslichtquelle ist die elektro-optische Grundkopplung dann in ausreichend weiten Grenzen einfach fein einstellbar. Der gewünschte Ruhepunkt (Arbeitspunkt) der Messanordnung kann somit sehr einfach eingestellt werden.

Vorteilhafterweise können so bisherige Messanordnungen des Stands der Technik verbessert werden. Insbesondere für Messanordnungen, bei denen wenigstens eine der Sendelichtquellen weit von der Photodiode entfernt ist, lässt sich auf diese Weise die notwendige Grundkopplung erzeugen. Die elektrische Erzeugung der optischen Grundkopplung kann für jede Sendelichtquelle individuell angepasst sein. Jede der einzelnen Regelschleifen mit ihren jeweiligen Sendelichtquellen lassen sich somit individuell mit den notwendigen Werten der Grundkopplung ausstatten.

Durch Einsatz einer elektrisch erzeugten optischen Grundkopplung (EOGK) mittels einer Grundkopplungslichtquelle entfällt folglich der hohe konstruktive Aufwand, die optische Grundkopplung der Sendelichtquelle ausschließlich mit mechano-optischen Mitteln genau einzustellen zu müssen. Damit wird die Entwicklung und Herstellung derartiger Messanordnungen deutlich einfacher und preiswerter. Die Entwicklung kann schneller erfolgen. Durch diesen Ansatz ist gerade die Verwendung mehrerer Sendelichtquellen, die teilweise weit von dem optischen Empfänger entfernt sind, überhaupt erst möglich. Somit steigt auch die Akzeptanz der Anwender für Messanordnungen nach dieser Messmethode. Die erfindungsgemäße Messanordnung überwindet somit wesentliche Nachteile im Stand der Technik.

Im Rahmen der Erfindung wurde erkannt, dass die Grundkopplungslichtquelle die Kompensationslichtquelle sein kann. In einer zweiten, bevorzugten Ausführungsform wird deshalb der Kompensator (d.h. die Kompensationslichtquelle) sowohl für die Kompensation als auch für die Erzeugung des Lichtanteils, welcher der EOGK entspricht, genutzt. Dafür muss der Strom des Kompensations-Stromtreibers und der Strom der Grundkopplungsstromquelle zusammengeführt (summiert) werden, was mit elektronischen Mittel einfach realisiert werden kann. Während der Kompensationsphase fließt nun der Kompensationsstrom durch den Kompensator und zusätzlich, erfindungsgemäß, während der Sendephase der Strom der Grundkopplungsstromquelle. Somit wird die Kompensationslichtquelle zweifach genutzt; eine zusätzliche Lichtquelle für die Erzeugung der EOGK ist in dieser zweiten Realisierungsvariante nicht mehr nötig.

Ein Sensor, der über die EOGK verfügt, wird vorzugsweise mit der kleinstmöglichen (rein) optischen Grundkopplung (die idealerweise Null ist) ausgelegt, damit der größtmögliche Betrag der von der Anwendung geforderten Grundkopplung elektro-optisch erzeugt werden kann. In diesem Fall ist die beste Flexibilität (Konfigurierbarkeit) bei höchster Stabilität gegeben, da der (rein) optische Grundkopplungsanteil verschiedenen, im Allgemeinen nicht zu vernachlässigenden Störeinflüssen unterliegt. Die Robustheit bezüglich vieler Störeinflüsse ist in der zweiten Realisierungsvariante besonders hoch. Im ungünstigsten Arbeitspunkt, dem Ruhezustand, nämlich dann, wenn kein Messobjekt vorhanden ist und keine optische Reflexion zur Photodiode gelangt, muss die ganze Messanordnung mit der niedrigsten Signalleistung auskommen. Der Regler regelt nur noch den relativ niedrigen Photodiodenstrom der EOGK mit dem vom Kompensator generierten Photodiodenstrom aus, um das Ruhe-Ausgangs-Signal zu erzeugen. Beide optischen Teil- Signale werden erfindungsgemäß in ein und demselben elektro-optischen Bauteil, nämlich der Kompensationslichtquelle erzeugt und unterliegen demnach in gleichem Maße den an dieses Teil gebundenen Störeinflüssen. Hier handelt es sich vornehmlich um den ungünstigen Temperaturkoeffizienten der Lichtausbeute der IR-LEDs von etwa -0,5%/K.

Überraschenderweise wurde auch festgestellt, dass bisherige, nach dem Stand der Technik realisierte Messanordnungen ohne großen Aufwand, lediglich durch die Ausstattung mit einer zusätzlichen Stromquelle wesentlich verbessert werden können.

In einer bevorzugten Ausführungsform der opto-elektronischen Messanordnung wird der über die Kompensationslichtquelle geführte Grundkopplungssteuerstrom auf höchstens 50%, 20 % oder 10 %, oder bei Sensoren mit größerer Reichweite auch auf deutlich niedrigere Prozentwerte des Sendersteuerstroms eingestellt. Bevorzugt ist dabei die (rein) optische Grundkopplung möglichst klein verglichen mit der funktionalen Objektkopplung (höchstens 5 % oder 2 % oder 1 % dieses Wertes), besonders bevorzugt annähernd Null. Die elektro-optische Grundkopplung (EOGK), die durch Regelung des Grundkopplungssteuerstroms der Grundkopplungsstromquelle erzeugt wird, ergänzt bzw. ersetzt folglich die geringe oder nicht vorhandene optische Grundkopplung der Sendelichtquelle.

In einer bevorzugten Ausführungsform umfasst eine Messanordnung mehrere Sendelichtquellen, die sequentiell hintereinander in einer Regelschleife durch die Kompensationslichtquelle kompensiert werden. Dazu erfolgt mittels des Reglers für jede der Sendelichtquellen eine Kompensation mit der Kompensationslichtquelle. Für jede dieser Regelschleifen wird jeweils ein optimierter und angepasster Grundkopplungssteuerstrom erzeugt, mit dem die regelbare Kompensationssteuerquelle angesteuert wird. Auf diese Weise kann für jede einzelne Sendelichtquelle eine individuelle elektro-optische Grundkopplung erzeugt werden.

In der Regel sind bei opto-elektronischen Messanordnungen in der Praxis die Regeleinheiten, Demodulatoren, Taktgeneratoren und Verstärker in einem Chip integriert. In diesem integrierten elektrischen bzw. elektronischen Bauteil sind auch die Signalgeber für die regelbaren Stromquellen bevorzugt umfasst. Die Stromquellen, insbesondere die steuerbare Sendelichtstromquelle und die Grundkopplungsstromquelle werden von einem oder von mehreren Signalgebern gesteuert. Bei einer Integration der Signalgeber, insbesondere des Signalgebers zur Steuerung der Grundkopplungsstromquelle entstehen in der Realisierung der opto-elektronischen Messanordnung keine nennenswerten (Hardware-) Mehrkosten. Lediglich bei der Chipentwicklung muss einmal ein höherer Aufwand betrieben werden. Insoweit ist die erfindungsgemäße Erweiterung der opto-elektronischen Messanordnung um das Merkmal der elektro-optischen Grundkopplung sehr kostengünstig.

Die erfindungsgemäße Messanordnung weist eine Vielzahl von Vorteilen auf. Durch die elektrische Realisierung der optischen Grundkopplung ergibt sich ein deutlich reduzierter Aufwand beim optischen Design (Optik-Design) der Messanordnung. Die Optik muss von den bisherigen drei technischen Schwerpunkten, nämlich möglichst optimales Senden, möglichst optimales Empfangen und die Erzeugung einer entsprechenden optische Grundkopplung, nur noch zwei dieser ursprünglich drei Anforderungen gleichzeitig erfüllen. Daraus ergeben sich deutlich geringere Anforderungen an das opto-mechanische Design der Messanordnung, insbesondere an die konstruktive Ausgestaltung. Da keine optische Grundkopplung von der Sendelichtquelle zum optischen Empfänger mehr gefordert ist, können praktisch die oft kritischen Grundkopplungspfade der bisherigen Sensoren umgangen werden.

Diese optischen Grundkopplungspfade unterliegen oft erheblichen Störeinflüssen. Beispielsweise beeinflussen Bauteil- und Montagetoleranzen, Materialeinflüsse, Oberflächenbeschaffenheiten die Grundkopplung nach dem Stand der Technik in vielen Fällen deutlich. Äußere Einflüsse wie Feuchte, Verschmutzung oder Kratzer auf Frontplatten sind noch kritischer. Diese Einflüsse entfallen bei Einsatz der elektro-optischen Grundkopplung weitestgehend. Darüber hinaus war zur Realisierung ein hohes fachspezifisches Wissen über die Grundkopplung und die optischen Strahlengänge im Sensor notwendig. Durch die erfindungsgemäße Messanordnung werden nun auch schwierige Anwendungen im Allgemeinen mit weniger Spezial-Know-How deutlich besser beherrschbar. Die Erfindung hat somit großen kommerziellen Nutzen.

Es hat sich gezeigt, dass sich mit der erfindungsgemäßen Messanordnung mit elektro-optischer Grundkopplung auch ein einfacheres Platinen-Layout ergibt. Das Layout der Schaltung ist weitgehend durch die optischen und mechanischen Anforderungen bestimmt. Diese sind nun jedoch deutlich reduziert. Ebenso ermöglicht die erfindungsgemäße Messanordnung eine exakte elektronische Realisierung der optimalen Grundkopplung. Dies ist für jede Sendelichtquelle und für die damit aufgebaute Regelschleife einfach möglich. Dadurch ergeben sich auch optimale Rauschwerte und Einschwingzeiten bei einer vorgegebenen Strahlungsleistung. Die Messanordnung arbeitet deshalb schneller und exakter.

Des Weiteren hat die Messanordnung ein vorteilhaftes thermisches Verhalten, da praktisch nur noch eine Lichtquelle bzw. LED, nämlich bevorzugt die Kompensationslichtquelle in die Grundkopplung einbezogen und an der Festlegung des Ruhewertes als grundlegendem Arbeitspunkt beteiligt ist.

Die Reduzierung oder der Wegfall der (rein) optischen Grundkopplung von der Sendelichtquelle zur Photodiode erlaubt ein einfacheres konstruktives Design Die Kombination des vereinfachten Designs mit der schnelleren und effektiveren Einstellmöglichkeit der elektro-optischen Grundkopplung führt zu verkürzten Entwicklungszeiten. Wo bisher z. B. Lichtleiter aufwändig simuliert und zur Überprüfung produziert werden mussten, kann mittels der Methode der elektro-optischen Grundkopplung der Strom der Grundkopplungslichtquelle, z. B. durch Austausch eines Widerstands, verändert werden und sehr kurzfristig eine neue Abstimmung des Sensors gefunden werden.

Ein weiterer Vorteil der Anordnung ergibt sich durch die freie Konfigurierbarkeit ein und derselben (physikalischen) Regelschleife, um nacheinander, also beispielsweise im Zeitmultiplex, grundsätzlich verschiedene Aufgaben mit der Messanordnung zu lösen. Es können so beispielsweise Annäherungsmessungen in größerem Abstand (wie etwa zwischen 20 und 70 cm) bei dem Durchlauf einer Regelschleife erfolgen, während in der nächsten Regelschleife die Erkennung der Berührung einer Sensoroberfläche (Touch-Erkennung) durchgeführt wird. Damit ist das System sehr flexibel, da die Grundkopplung auf elektro-optischem Wege für jeden Regelzyklus im laufenden Betrieb angepasst (umparametriert) werden kann. Die erfindungsgemäße Messanordnung ist somit sehr flexibel und vielseitig einsetzbar. Sie weist eine hohe Stabilität auf, bei der der Arbeitspunkt gezielt einstellbar ist. Beispielsweise kann durch eine gezielte Abstimmung des Arbeitspunkts die Empfindlichkeit des Sensors erhöht werden, andererseits lässt sich auch die Robustheit der Regelung optimieren.

Die Erfindung wird nachfolgend anhand von in den Figuren dargestellten besonderen Ausführungsformen näher erläutert. Die dort dargestellten Besonderheiten können einzeln oder in Kombination verwendet werden, um bevorzugte Ausgestaltungen der Erfindung zu schaffen. Die beschriebenen Ausführungen stellen keine Einschränkung der durch die Ansprüche in ihrer Allgemeinheit definierten Erfindung dar. Es zeigen:

Fig. 1          ein Prinzipbild einer Messanordnung des Stands der Technik (nach der HALIOS®-Messmethode);

Fig. 2          eine Prinzipschaltung der erfindungsgemäßen Messanordnung in der Realisierung mit einer zusätzlichen LED für die EOGK;

Fig. 3          eine Prinzipschaltung der erfindungsgemäßen Messanordnung in der Realisierung mit Nutzung der KompensationsLED für die EOGK;

Fig. 4          eine Prinzipschaltung einer Ausführungsform der EOGK gemäß der Messanordnung in Fig. 2;

Fig. 5          eine Prinzipschaltung einer Ausführungsform der EOGK gemäß der Messanordnung in Fig. 3;

Fig. 6a, b, c,     d weitere Realisierungsmöglichkeiten der EOGK im IC.

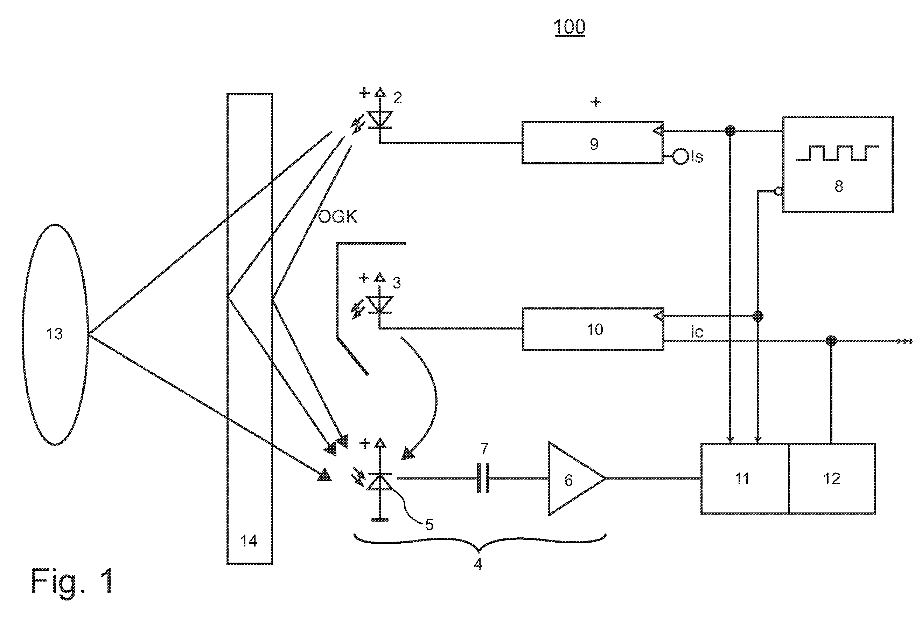

Fig. 1 zeigt eine Messanordnung 100 gemäß dem Stand der Technik. Die Messanordnung 100 umfasst eine Sendelichtquelle 2, eine Kompensationslichtquelle 3 und einen optischen Empfänger 4, der eine Photodiode 5 und eine Verstärkereinheit 6 einschließt. Die Verstärkereinheit 6 ist als Transimpedanzverstärker ausgebildet, wobei zwischen dem Transimpedanzverstärker 6 und der Photodiode 5 mindestens ein Kondensator 7 geschaltet ist. In der EMV-gerechten differenziellen Ausführung der Ankopplung der Photodiode 5 werden zwei Kondensatoren 7 an dieser Stelle vorgesehen.

Ein Taktgenerator 8 taktet eine steuerbare Stromquelle 9, die die Sendelichtquelle 2 speist. Der Taktgenerator 8 liefert auch ein invertiertes Taktsignal an eine steuerbare Kompensationsstromquelle 10, die die Kompensationslichtquelle 3 speist. Sowohl das Taktsignal als auch das invertierte Taktsignal des Taktgenerators 8 werden einem Demodulator 11 zur taktsynchronen Auswertung des von dem optischen Empfänger 4 auf Grund der empfangenen Lichtsignale erzeugten Ströme bzw. Spannungen zugeführt.

Eine Reglereinheit 12 der Messanordnung 100 erzeugt ein Ansteuersignal für die regelbare Kompensationsstromquelle 10, so dass die Kompensationslichtquelle 3 derart geregelt werden kann, dass der zwischen den in den beiden Phasen empfangenen Signale von der Sendelichtquelle 2 und der Kompensationslichtquelle 3 empfangenen Lichtanteilen in der Amplitude gleich werden.

In den Regelvorgang kann auch die Senderstromquelle mit einbezogen werden, wobei diese gegenläufig zur Kompensationsstromquelle geregelt wird.

Ist ein Messobjekt 13 in der Nähe der Messanordnung 100 vorhanden, so wird von der Sendelichtquelle 2 ausgestrahltes Licht vom Messobjekt 13 zur Photodiode 5 reflektiert. Gleichzeitig zu diesem Signalanteil empfängt die Photodiode 5 auch das von der Sendelichtquelle 2 gesendete Licht der optischen Grundkopplung (OGK). Als weitere Komponente empfängt die Photodiode 5 den von der Kompensationslichtquelle 3 ausgesendeten Lichtanteil.

Zur Ausregelung der Messanordnung 100 ergibt sich damit folgende Regelbedingung:

$$\frac{I_c}{I_s} = \frac{\eta_s}{\eta_c} \bullet \frac{D_{SG} + D_{SF}}{D_c} \qquad \text{(Gleichung 1)}$$

$I_c$ und $I_s$ sind die Ansteuersignale bzw. Ansteuerströme für die regelbare Stromquelle 9 der Sendelichtquelle 2 bzw. für die regelbare Kompensationsstromquelle 10 der Kompensationslichtquelle 3. $\eta_s$ bzw. $\eta_c$ ist die jeweilige Effizienz der Sendelichtquelle 2 bzw. der Kompensationslichtquelle 3. $D_{SG}$ ist die optische Grundkopplung zwischen Sendelichtquelle 2 und Photodiode 5. $D_{SF}$ ist die funktionale, veränderliche optische Kopplung zwischen Sendelichtquelle 2 und Photodiode 5 über das Messobjekt 13, während $D_c$ die konstante optische Kopplung der Kompensationslichtquelle 3 zur Photodiode 5 darstellt.

Die optische Grundkopplung ($D_{SG}$) wird im Stand der Technik durch eine entsprechende Konstruktion bzw. opto-funktionale Gestaltung der Messanordnung 100 auf den gewünschten Wert eingestellt. Der Anteil $D_{SF}$ ist der gesuchte Anteil, der die Informationen über das Messobjekt 13 enthält.

Das Verhältnis aus den Effizienzzahlen der Sendelichtquelle 2 und der Kompensationslichtquelle 3 ist in der Regel ausreichend gut bestimmt und in erster Näherung konstant. So kann dieses Verhältnis gemäß Gleichung 1 bestimmt werden. Das Ansteuersignal $I_s$ für die steuerbare Stromquelle 9 der Sendelichtquelle 2 ist bekannt, im Einzelfall sogar konstant. Der von der Reglereinheit ermittelte Ansteuerstrom $I_c$ für die Kompensationsstromquelle 10 ist im ausgeregelten Zustand direkt proportional zur gesuchten (funktionalen) optische Messobjektkopplung $D_{SF}$.

Ist kein Messobjekt 13 vorhanden, so ist die (funktionale) optische Messobjektkopplung $D_{SF}$ gleich Null. Der vom Regler ermittelte Arbeitspunkt ist somit genau der Ruhewert, der der optischen Sender-Grundkopplung entspricht.

Nachteilig im Stand der Technik ist, dass die optische Grundkopplung durch (rein) konstruktive Maßnahmen der Messanordnung 1 erzielt werden muss. Beispielsweise kann eine vorhandene Sensorabdeckung 14, die teiltransparent sein kann, in einigen Bereichen derart beschichtet sein, dass eine gewünschte Grundkopplung erzielt wird. Insbesondere bei vergleichsweise weit von der Photodiode 5 entfernten Sendelichtquellen 2 ist der Grundkopplungsanteil jedoch üblicherweise gering, so dass teilweise nicht der gewünschte Ruhewert nach dem Stand der Technik eingestellt werden kann. Dies gelingt erst, indem durch zum Teil aufwändige konstruktive Maßnahmen die Grundkopplung verbessert bzw. erhöht wird.

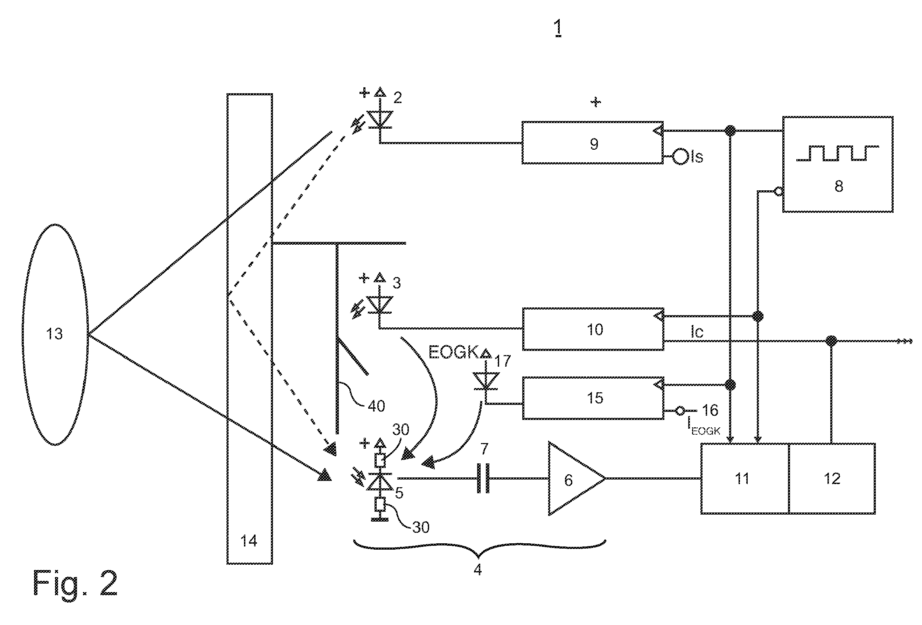

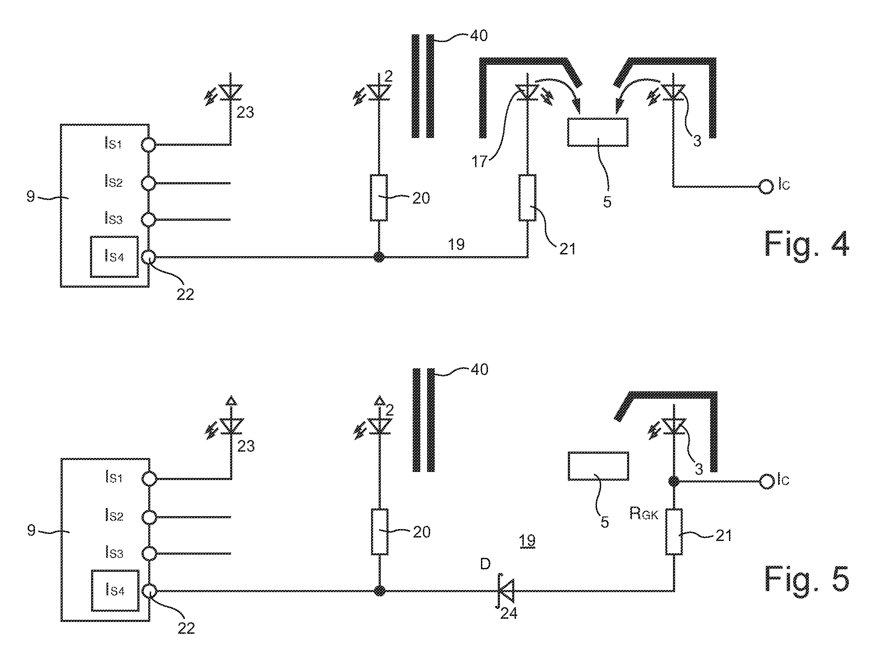

Im Vergleich dazu zeigt Fig. 2 eine erfindungsgemäße Messanordnung 1, bei der die Grundkopplung der Sendelichtquelle 2 derart gering ist, dass sie höchstens 7 % oder 5 % beträgt oder vernachlässigt werden kann. (Die hier genannten Prozentwerte beschreiben die optische Grundkopplung im Bezug auf die Werte der funktionalen Objektkopplung). Ergibt sich dies in der Konstruktion nicht von selbst, kann beispielsweise durch einfache konstruktive Maßnahmen die Reduzierung der optischen Grundkopplung erzielt werden. Beispielsweise kann eine optische Abschottung der Sendelichtquelle 2 von der Photodiode 5 durch die in Fig.4 angedeutete, einfache opto-mechanische Abschirmung 40 erreicht werden, oder indem die Sendelichtquelle ausreichend tief in einer (engen) Sendekammer positioniert wird.

Zusätzlich zu der regelbaren Stromquelle 9 und der regelbaren Kompensationsstromquelle 10 umfasst die erfindungsgemäße Messanordnung 1 eine weitere regelbare Stromquelle, die Grundkopplungsstromquelle 15. Sie wird zum einen mit dem Taktsignal des Taktgenerators 8 getaktet. Gleichzeitig wird sie von einem Signalgeber 16, dem sogenannten Grundkopplungssignalgeber eingestellt oder sogar mit der Sendersteuerstromquelle mit geregelt. Der in der Grundkopplungsstromquelle 15 erzeugte getaktete Grundkopplungssteuerstrom wird einer Grundkopplungslichtquelle 17 zugeführt, die Licht zu der Photodiode 5 sendet.

Die (rein) optische Grundkopplung der Sendelichtquelle 2 wird also ersetzt oder entsprechend ergänzt durch eine elektrisch erzeugte optische Grundkopplung (EOGK), die mit der Grundkopplungslichtquelle 17 hergestellt wird. Diese elektro-optische Grundkopplung der Grundkopplungslichtquelle 17 hat den Vorteil, dass sie nicht mehr von der Sendelichtquelle und deren z.B. optischen oder räumlichen Gegebenheiten abhängt. Die Grundkopplungslichtquelle 17 lässt sich deshalb weitestgehend unabhängig, i. d. R. optimal einstellen. Somit ist die erfindungsgemäße Messanordnung 1 den bekannten Messanordnungen 100 überlegen.

Um die Fremdlichtunempfindlichkeit des Empfangsteils insbesondere der Photodiode 5 weiter zu verbessern, werden in den Versorgungszuleitungen der Photodiode 5 Stromtiefpässe eingebaut, die die Gleichanteile und niederfrequenten Signalanteile des Photodiodenstromes (hervorgerufen vor allem durch Fremdlicht) an die Versorgung ableiten, um sie optimal von den hochfrequenten Messsignalen zu trennen. Dadurch können die hochfrequenten Messsignale vorzugsweise differenziell über zwei Hochpässe (realisiert als Koppelkondensatoren) optimal (EMV-gerecht) in den vorzugsweise differenziellen Transimpedanzverstärker 6 eingekoppelt werden. Die Stromtiefpässe können vorzugsweise als (aktive) Gyrator-Schaltungen, also mit Transistoren oder MOSFETs, oder mit passiven Bauteilen, also mit Induktivitäten, realisiert werden.

Fig. 2 ist zu entnehmen, dass die Grundkopplungslichtquelle 17 mit der selben Phase getaktet ist wie die Sendelichtquelle 2, also auch um 180 Grad phasenverschoben zur Kompensationsstromquelle 10.

In einer bevorzugten Ausführungsform sind die Sendelichtquelle 2, die Kompensationslichtquelle 3 und/oder die Grundkopplungslichtquelle 17 als lichtemitierende Diode (LED), ausgeführt.

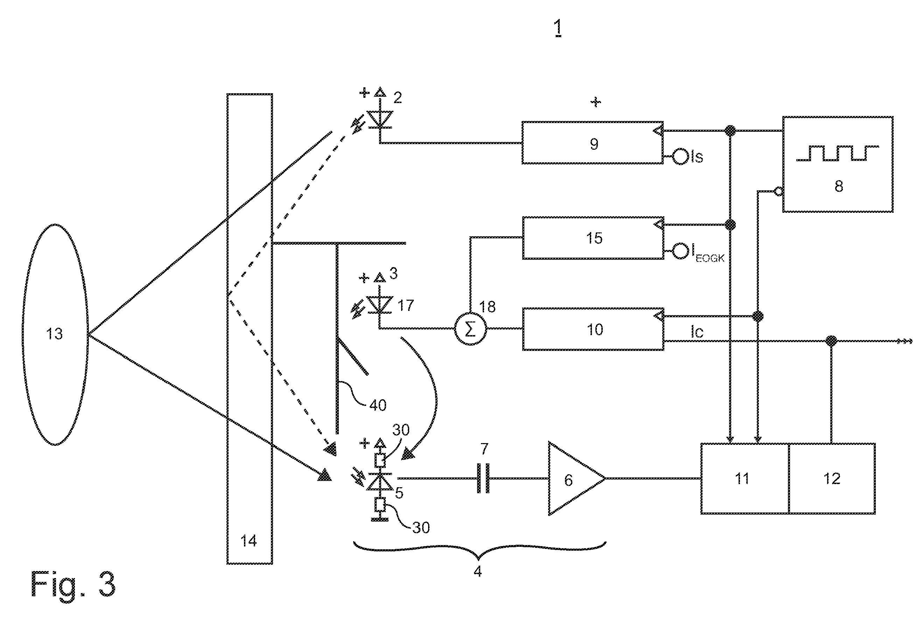

Fig. 3 zeigt eine zweite, alternative, i. d. R. bevorzugte, Ausführungsform der erfindungsgemäßen Messanordnung 1, bei der die Grundkopplungslichtquelle 17 die Kompensationslichtquelle 3 selbst ist. Die Kompensationslichtquelle 3 übernimmt also auch die Funktion der Grundkopplungslichtquelle 17. Die regelbare Grundkopplungsstromquelle 15 speist folglich die Kompensationslichtquelle 3 ebenso wie die regelbare Kompensationsstromquelle 10 dies bereits im Stand der Technik tut. Bevorzugt werden der Kompensationssteuerstrom für die Kompensationsstromquelle 10 und der Grundkopplungssteuerstrom für die Grundkopplungsstromquelle 15 in einem Additionsglied 18 miteinander addiert und gemeinsam der Kompensationslichtquelle 3 zugeführt. Da die Steuerströme der Grundkopplungsstromquelle 15 und der Kompensationsstromquelle 10 phasenverschoben sind, ergibt sich praktisch ein zeitlich zusammengesetzter Steuerstrom. Die gewünschte elektro-optische Grundkopplung der Messanordnung ist an die Kompensatorkopplung geknüpft, was einen großen Stabilitätsgewinn für den Ruhewert bedeutet, und sie verfügt über den großen Vorteil, dass der benötigte Wert über die frei verfügbare Stromamplitude von $I_{EOGK}$ eingestellt wird.

Die elektro-optische Grundkopplung wird also durch das Ansteuersignal ($I_{EOGK}$) zur Ansteuerung der Grundkopplungsstromquelle 15 endgültig festgelegt. Da dies durch einen elektrischen Signalgeber 16 erfolgt, ist die Grundkopplung auch später auf einfache Weise änderbar. Es muss lediglich ein anderes (schnell und einfach geändertes) Ansteuersignal für die Grundkopplungsstromquelle 15 erzeugt werden. Die erfindungsgemäße Messanordnung 1 ist insgesamt sehr flexibel und kann auch im Nachhinein für andere Aufgaben adaptiert werden. Es sind keine konstruktiven Maßnahmen innerhalb der Messanordnung 1 notwendig, insbesondere keine zusätzlichen Abschirmungen oder Beschichtungen einer Sensorabdeckung 14 oder Abdeckung der Messanordnung 1. So lässt sich auch später der Ruhe-Arbeitspunkt der Messanordnung 1 noch verändern und somit die Empfindlichkeit oder Dynamik oder Genauigkeit an neue oder geänderte Anforderungen anpassen.

In der Regel ist davon auszugehen, dass die (rein) optische Grundkopplung (nach dem Stand der Technik) von der Sendelichtquelle 2 zum optischen Empfänger 4 deutlich unter 10 % liegt. In der Praxis ist die optische Grundkopplung maximal 6 %, 5 % oder darunter. Insbesondere bei weiter entfernten Sendelichtquellen 2, wie es beispielsweise bei räumlich relativ ausgedehnten Konstruktionen und Messanordnungen 1 der Fall ist, liegt die optische Grundkopplung bei 3 %, 2 % oder maximal 1 %. Es ist ohne weiteres möglich, bei weiter entfernt liegenden Sendelichtquellen 2 die optische Grundkopplung mittels geringem Aufwand und durch einfache Maßnahmen auf maximal 0,5 % oder bevorzugt 0,1 % (vom funktionalen Signal) zu reduzieren. Die optische Grundkopplung $D_{SG}$ der Sendelichtquelle 2 kann also vernachlässigt werden. Sie wird komplett durch die elektro-optisch erzeugte Grundkopplung $D_{EOGK}$ von der Grundkopplungsstromquelle 15 ersetzt. (Die hier genannten Prozentwerte beschreiben die optische Grundkopplung im Bezug auf die Werte der funktionalen Objektkopplung).

Aus der oben genannten Gleichung 1 folgt deshalb für die erfindungsgemäße Messanordnung 1 unter der Bedingung, dass $D_{SG} \ll D_{EOGK}$ ist, die Gleichung 2:

$$\frac{I_c}{I_s} = \frac{\eta_s}{\eta_c} \cdot \frac{D_{SF} + D_{EOGK}}{D_c}$$

Der Kompensationssteuerstrom $I_c$ zur Einstellung des Arbeitspunktes ohne Messobjekt, also des Ruhewertes, ist somit nur von der elektro-optischen Grundkopplung $D_{EOGK}$ abhängig und wird somit nur durch den Grundkopplungssteuerstrom ($I_{EOGK}$) eingestellt. Mathematisch betrachtet, fällt in dem Ruhezustand (Arbeitspunkt = Ruhewert) die (gesamte) Übertragungsfunktion der Kompensationslichtquelle aus den Systemgleichungen heraus. (Ähnlich wie dies auf der Empfänger-Seite bereits im Stand der Technik der Fall ist.)

In einer bevorzugten, nicht im IC integrierten, Ausführungsform ist die Grundkopplungsstromquelle 15 nicht als eigene Stromquelle realisiert. Vielmehr wird die regelbare Stromquelle 9 zur Erzeugung des getakteten Sendesteuerstroms für die Sendelichtquelle 2 dafür gleich mit genutzt, indem ein in der Regel kleiner Stromanteil durch die Kompensatorlichtquelle 17 geleitet wird,

Fig. 4 zeigt einen Stromteiler 19 der die Stromteilung bei Verwendung einer eigenen (separaten) Grundkopplungslichtquelle 17 realisiert. Der Sendesteuerstrom, der an einem Stromtreiberausgang 22 ($I_{S4}$) in Fig. 4 anliegt, wird über einen ohmschen Spannungsteiler 19, der aus den Widerständen 20 und 21 besteht, gebildet. Der Strom am Stromtreiberausgang 22, der der regelbaren Stromquelle 9 entspricht, wird im umgekehrten Verhältnis der Widerstände 20 und 21 zwischen der Sendelichtquelle 2 und der Grundkopplungslichtquelle 17 aufgeteilt. Hierbei ist die Grundkopplungslichtquelle 17 für die elektro-optisch erzeugte Grundkopplung verantwortlich. Diese kann somit unabhängig von der Kompensatorkopplung $D_C$ der Kompensationslichtquelle 3 gewählt und eingestellt werden.

Wenn durch das Abzweigen des Stromes für die Erzeugung der EOGK in der Sendelichtquelle 2 zu wenig optische Leistung entstehen sollte, kann parallel zur Sendelichtquelle 2 eine weitere Sendelichtquelle 23 zugeschaltet werden, die synchron zur Sendelichtquelle 2 bestromt wird.

Die Anordnung gemäß Fig. 4 hat jedoch den Nachteil, dass eine zusätzliche Lichtquelle 17 benötigt wird. Wird darauf verzichtet und der Stromteiler-Widerstand auf die Kompensatorlichtquelle 3 geführt, so entsteht eine kostengünstigere Realisierung nach dem Prinzipschaltbild in Fig.3.

Je nach Dimensionierung der Stromteiler-Widerstände kann eine geringe Mitkopplung der Sendelichtquelle 2 während der Kompensationsphase entstehen. D.h. ein geringer oder auch sehr geringer Teil des Kompensationsstromes aus der Kompensatorstromquelle fließt durch die Sendelichtquelle 2. In einigen Anwendungen kann eine derartige Mitkopplung sogar erwünscht sein, beispielsweise zur Ausgangs-Kennlinienformung. Soll eine derartige Mitkopplung der Sendelichtquelle 2 jedoch gänzlich verhindert werden, eignet sich eine Schaltungsanordnung gemäß Fig. 5. Die Diode 24 verhindert den Stromfluss durch die Sendelichtquelle in die Kompensatorstromquelle während der Kompensationsphase. Bevorzugt ist die Diode 24 eine Schottky-Diode, damit das Stromteilerverhältnis aufgrund der kleinen Durchlassspannung der Schottky-Diode möglichst wenig gestört ist. Allerdings sind hierbei Temperatureinflüsse, die durch die Schottky-Diode auftreten können, zu beachten, insbesondere dann, wenn für die Stromteilung nur eine geringe Spannung zur Verfügung steht. Vorteilhaft an dieser Ausführung ist jedoch, dass grundsätzlich keine zusätzliche Grundkopplungslichtquelle notwendig ist.

Die Anordnungen gemäß den Fig. 4 und 5 können als technischer Zwischenschritt bei der Realisierung der Grundkopplungsstromquelle 15 mit diskreten Bauteilen angesehen werden, solange das Merkmal EOGK noch nicht in einem Chip integriert ist. Die Integration der EOGK in den Chip (z.B. IC oder ASIC) stellt natürlich die einfachste, flexibelste, robusteste, platzsparendste und gleichzeitig kostengünstigste Lösung dieser Aufgabe dar.

Durch die Integration der elektro-optischen Grundkopplungsfunktion in den Regelungschip entstehen keine Mehrkosten bei der Realisierung dieser Funktion. Lediglich bei der Chipentwicklung muss diese Funktion einmalig integriert werden. In Bezug auf den reinen Hardware-Aufwand, wie beispielsweise den Platzbedarf oder die Temperaturstabilität oder ähnlicher Werte bzw. Charakteristika ist die IC-Lösung optimal. Die Integration der elektro-optischen Grundkopplungsfunktion in den Regelungschip ermöglicht es, mit den Sendesteuerströmen phasensynchrone Grundkopplungssteuerströme in die Kompensationslichtquelle 3 bzw. eine Kompensationstreiberschaltung einzuspeisen.

Diese Ströme sind frei parametrisierbar auf einen beliebigen Wert oder auf eine einstellbare Proportionalität zu dem Sendesteuerstrom. Insgesamt ergibt sich hierdurch ein sehr flexibler Einsatz dieser Funktion.

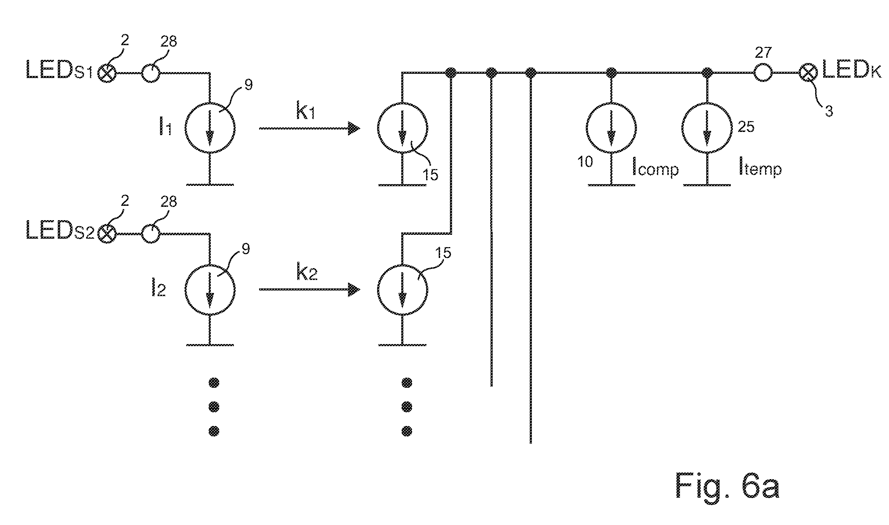

Die Figuren 6a bis d zeigen das Prinzipbild des Regelungschips der Messanordnung 1 für den Fall, dass mehrere Sendelichtquellen 2 vorhanden sind. Die als $LED_{S1}$ und $LED_{S2}$ bezeichneten Sendelichtquellen 2 werden jeweils an einem Senderstromtreiberausgang 28 angeschlossen und durch eine steuerbare Stromquelle 9 ($I_1$, $I_2$) gespeist. Gleiches gilt für weitere (nicht gezeigte) Sendelichtquellen 2, die dann als $LED_{S3}$, $LED_{S4}$, ... bezeichnet werden.

Die für die erfindungsgemäße Messanordnung 1 erforderliche Kompensationslichtquelle 3 ist ebenfalls als LED ausgeführt und wird als $LED_K$ bezeichnet. Sie ist an den Kompensationsstromtreiberausgang 27 der Schaltung angeschlossen. Darüber hinaus ist in den Figuren 6a bis d auch eine steuerbare Kompensationsstromquelle 10 gezeigt, um die Kompensationslichtquelle 3 anzusteuern.

Eine weitere Stromquelle zur Kompensation von Temperatureinflüssen ist parallel zur Kompensationsstromquelle 10 geschaltet. Diese Stromquelle wird als Temperaturkompensationsstromquelle 25 bezeichnet. Sie liefert vorzugsweise nur während eines Regelzyklus einen zusätzlichen Gleichstrom (i. d. R. von einigen wenigen mA) in die Kompensationslichtquelle, mit dem Ziel den elektro-optischen Arbeitspunkt der Kompensationslichtquelle 3, insbesondere eine LED oder IR-LED, vergleichbarer zu machen mit dem elektro-optischen Arbeitspunkt der Sendelichtquelle(n) 3, die mit wesentlich höheren Strömen und Verlustleistungen (Eigenerwärmung) arbeiten. Für die Messsignale hat dieser zusätzliche Gleichstrom keine Bedeutung, da er von der kapazitiven Kopplung 7 im Empfänger wieder herausgefiltert wird. Die Temperaturstabilität der Messanordnung wird durch diese Maßnahme deutlich verbessert.

Die Ausführungsform gemäß Fig. 6a zeigt ein Prinzipbild der Schaltung ähnlich der Schaltung in den Figuren 4 und 5. Anstelle eines ohmschen Spannungsteilers 19 (Fig. 4, 5) werden einzelne Grundkopplungsstromquellen 15 eingesetzt, die die jeweiligen Widerstände ersetzen. Dies hat den Vorteil, dass für jede Applikation eine einfache Anpassung der Messschaltung lediglich durch Änderung des Stromwerts in der steuerbaren Grundkopplungsstromquelle 15 erzeugt werden kann. Jede Sendestromquelle 9 der einzelnen $LED_{S1}$, $LED_{S2}$, ... weist eine korrespondierende Grundkopplungsstromquelle 15 auf. Dabei besteht ein fester, linearer Zusammenhang zwischen dem Sendestrom der jeweiligen Sendestromquelle 15 für die einzelnen $LED_{S1}$, $LED_{S2}$, ... und dem Grundkopplungsstrom der Grundkopplungsstromquelle 15 der jeweiligen Sendelichtquelle ($LED_{S1}$, $LED_{S2}$, ...). Die Verwendung der Grundkopplungsstromquellen 15 hat den Vorteil, dass der Faktor $k_1$, $k_2$, ..., der der Grundkopplungsfaktor der jeweiligen Sendelichtquelle 2 ist, in weiten Grenzen, nahezu beliebig parametrisiert sein kann. In der Regel wird der Faktor $k_1$, $k_2$, ... jeweils kleiner 1 gewählt. Es ist selbstverständlich auch möglich, Grundkopplungsfaktoren $k_i$ größer 1 oder gleich 1 auszuwählen. Die einzelnen Grundkopplungsfaktoren $k_i$ (i = 1, 2, ...) sind vorzugsweise unterschiedlich, da sie von der jeweiligen Sendelichtquelle 2 und deren Positionierung in der Anordnung abhängen.

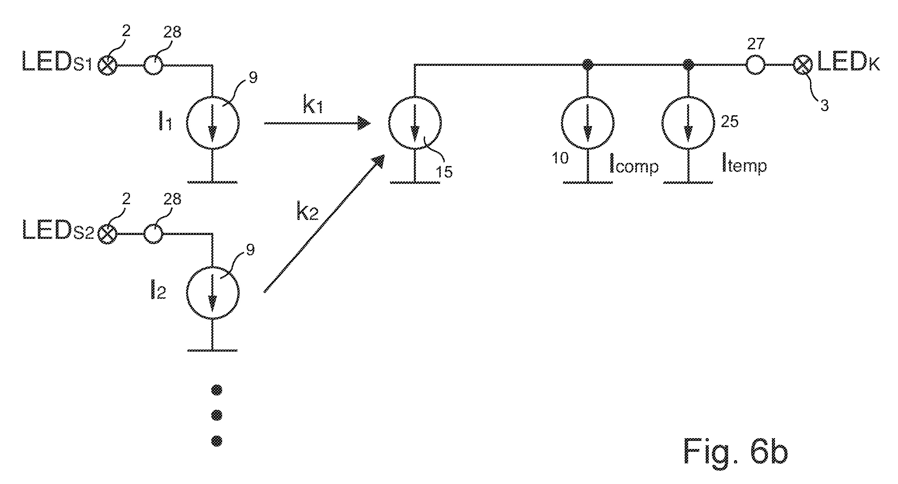

Fig. 6b zeigt eine alternative Ausführungsform, bei der die einzelnen Grundkopplungsstromquellen 15 für die einzelnen Sendelichtquellen 2 entfallen, bis auf eine einzige Grundkopplungsstromquelle 15. Diese Grundkopplungsstromquelle 15 wird im Zeit-Multiplexverfahren betrieben und erzeugt so für jede Sendelichtquelle 2 einen entsprechenden Grundkopplungsstrom, indem nacheinander die entsprechenden Steuersignale auf die einzige Grundkopplungsstromquelle durchgeschaltet werden. Dabei wird der jeweilige Grundkopplungsstrom nacheinander für die Sendelichtquellen am Kompensationsstrom-Treiberausgang 27 erzeugt. Es besteht also ein eigener Grundkopplungsfaktor $k_i$ (i = 1, 2, ...) zwischen der Grundkopplungsstromquelle 15 und den einzelnen Sendestromquellen 9 (für $LED_{S1}$, $LED_{S2}$, ...).

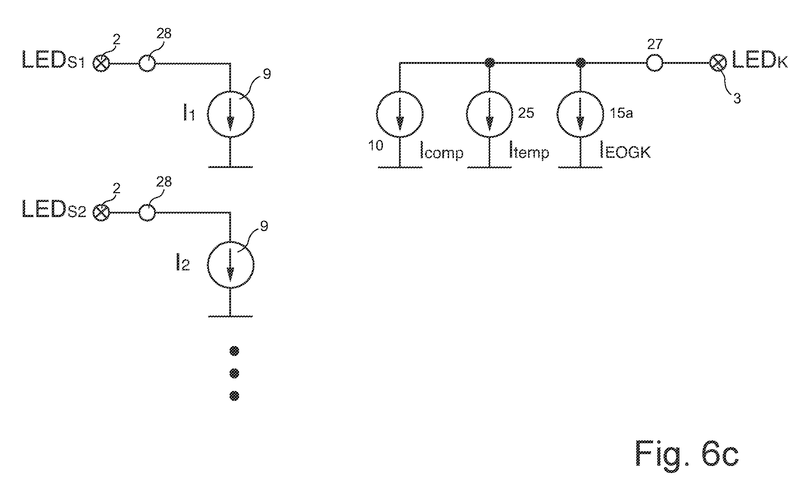

Fig. 6c zeigt eine Ausführungsform, bei der der lineare Zusammenhang zwischen der Sendestromquelle 2 und der Grundkopplungsstromquelle 15 aufgehoben wird. Anstelle der bisherigen Grundkopplungsstromquellen 15 ist nur noch eine in der Stromamplitude fest einstellbare Grundkopplungsstromquelle 15a vorhanden. Die direkte Proportionalität zwischen dem (geregelten) Sendestrom und Grundkopplungsstrom wurde hier aufgegeben. Diese Vereinfachung bezieht ihre Berechtigung aus der Tatsache, dass die Hauptfunktion der elektro-optischen Grundkopplung das definierte Ausregeln des Ruhewertes bei fehlendem Messobjekt ist. Bei dieser Ausführung der EOGK wird in Abhängigkeit von der Applikation ein fester Stromwert der Grundkopplungsstromquelle 15 für die jeweilige Sendelichtquelle 2 ($LED_{S1}$, $LED_{S2}$, ...) individuell eingestellt, um die jeweils gewünschte elektro-optische Grundkopplung zu erzielen.

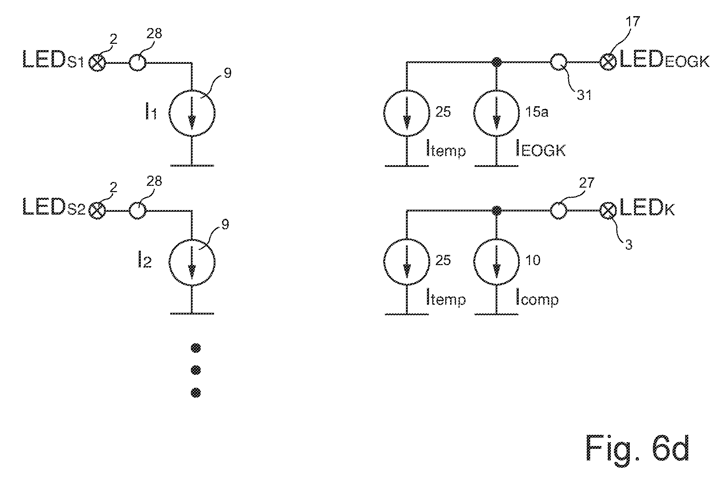

In den Ausführungsformen gemäß den Figuren 6a bis d wird jeweils die Kompensationslichtquelle 3 als Grundkopplungslichtquelle 17 vom IC vorgeschrieben, da es nur einen entsprechenden Stromtreiberausgang 27 gibt. In der allgemeinsten IC-Ausführung, wie in Fig. 6d gezeigt, kann wiederum eine separate Grundkopplungslichtquelle 17, unabhängig von der und zusätzlich zur Kompensationslichtquelle 3 verwendet werden. Die Grundkopplungslichtquelle 17 wird von der Grundkopplungsstromquelle 15a über den separaten Treiberausgang 31 gesteuert. Alle drei Abhängigkeiten zwischen der Grundkopplungsstromquelle 15, 15a und den Senderstromquellen 9 sind entsprechend den Realisierungen in Fig. 6a bis c, auch hier möglich. Durch Kurzschließen (Summieren) der Treiberausgänge 27 und 31 entsteht genau der Fall in Fig. 6c. Somit kann auf die separate Grundkopplungslichtquelle $LED_{EOGK}$ bei Bedarf bei dieser IC-Variante auch verzichtet werden.

Wie in Fig. 6d gezeigt, sollte der Grundkopplungsstromquelle 15a auch eine Temperaturkompensationsstromquelle 25 parallel geschaltet sein, um Temperatureinflüsse zu kompensieren bzw. zu minimieren. Dies ist notwendig, da die von der Grundkopplungsstromquelle 15a generierten Messströme mitunter sehr klein sein können.

## Patentansprüche

1.  Opto-elektronische Messanordnung, die fremdlichtunabhängig ist, umfassend

    - eine Sendelichiquelle (2) und eine Kompensationslichtquelle (3), die Licht zeitsequentiell getaktet, phasenweise aussenden, wobei das ausgesendete Licht jeweils phasenverschoben ist,
    - einen optischen Empfänger (4), mit einer Photodiode (5) zum Empfangen von Licht, das ein von den Lichtquellen (2, 3) ausgesendetes taktsynchrones Messsignal umfasst, und mit einer Verstärkereinheit (6) zum Verstärken eines auf dem empfangenen Messsignal beruhenden Messsignalstroms,
    - einen Taktgenerator (8) zur Erzeugung eines Taktsignals,
    - einen Demodulator (11) zur taktsynchronen Auswertung des Messsignalstroms,
    - eine regelbare Stromquelle (9) zur Erzeugung eines getakteten Sendesteuerstroms für die Sende-Lichtquelle (2),
    - eine regelbare Kompensations-Stromquelle (10) zur Erzeugung eines getakteten Kompensationssteuerstroms für die Kompensationslichtquelle (3), und

- eine Reglereinheit (12) zur Erzeugung wenigstens eines Ansteuersignals für die regelbare Stromquelle (9) und/oder KompensationsStromquelle (10), wobei die Reglereinheit (12) so ausgebildet ist, dass die Kompensationslichtquelle (3) und/oder die Sende-Lichtquelle (2) durch Steuerung des Kompensationssteuerstroms und/oder des Sendesteuerstroms in ihrer Lichtintensität in der Amplitude derart regelbar ist, dass die zwischen den unterschiedlichen Phasen auftretende taktsynchrone Signaldifferenz zu Null wird,

**gekennzeichnet durch**

- eine regelbare Grundkopplungs-Stromquelle (15) zur Erzeugung eines getakteten Grundkopplungs-Steuerstroms,
- eine Grundkopplungs-Lichtquelle (17), die von der Sende-Lichtquelle (2) verschieden ist und mit dem Grundkopplungs-Steuerstrom gespeist wird und Licht direkt zu dem optischen Empfänger (4) sendet;
- das der Grundkopplungs-Steuerstrom derart eingestellt wird, dass eine gewünschte Empfindlichkeit der Messanordnung (1) erzielt wird und/oder ein gewünschter Ruhewert der Reglereinheit (12) einstellbare ist,
- wobei ohne Anwesenheit eines zu erfassenden Objekts (13) die Reglereinheil (12) die Sende-Lichtquelle (2) und/oder die Kompensationslichtquelle (3) derart regelt, dass das von der GrundkopplungsLichtquelle (15) empfangene Messsignal ausgeregelt wird,

wobei

- die regelbare Stromquelle (9) zur Erzeugung eines getakteten SendeSteuerstroms und die regelbare Grundkopplungs-Stromquelle (15) zur Erzeugung eines getakteten Grundkopplungs-Steuerstroms mit dem Taktsignal des Taktgenerators (8) getaktet werden,
- die regelbare Kompensations-Stromquelle (10) zur Erzeugung eines getakteten Kompensationssteuerstroms mit dem invertierten Taktsignal des Taktgenerators (8) getaktet wird.

2. Messanordnung nach Anspruch 1, **dadurch gekennzeichnet, dass** die mit dem Grundkopplungs-Steuerstrom gespeiste Grundkopplungs-Lichtquelle (17) die Kompensationslichtquelle (3) ist und die Messanordnung (1) ein Additionsglied (18) umfasst, in dem der Grundkopplungs-Steuerstrom und der Kompensationssteuerstrom addiert werden, bevor sie der Kompensationslichtquelle (3) zugeführt werden.

3. Messanordnung nach Anspruch 1 oder 2, **dadurch gekennzeichnet, dass** die Sende-Lichtquelle (2) derart angeordnet ist, dass die Grundkopplung zwischen der Sende-Lichtquelle (2) und der Photodiode (5) maximal 50% der funktionalen optischen Objektkopplung, erzeugt durch die Sendelichtquelle (2) ist, bevorzugt maximal 20%, 10%, 7%, 5%, 2%, 1 % oder bevorzugt annähernd Null ist oder keine direkte Grundkopplung besteht.

4. Messanordnung nach einem der vorhergehenden Ansprüche, **dadurch gekennzeichnet, dass** der Grundkopplungs-Steuerstrom derart eingestellt wird, dass die elektro-optische Grundkopplung der Kompensations-Lichtquelle (3) generiert und/oder verändert wird.

5. Messanordnung nach einem der vorhergehenden Ansprüche, **dadurch gekennzeichnet, dass** die Sende-Lichtquelle (2), die Grundkopplungs-Lichtquelle (17) und/oder die Kompensationslichtquelle (3) mit jeweils einer LED realisiert ist.

6. Messanordnung nach einem der vorhergehenden Ansprüche, **dadurch gekennzeichnet, dass** die Grundkopplungs-Stromquelle (15) durch die Stromquelle zur Erzeugung eines getakteten Sende-Steuerstroms für die Sende-Lichtquelle (2) und einen Stromteiler (19), bevorzugt durch ohmsche Widerstände (20, 21), realisiert ist.

7. Messanordnung nach dem vorhergehenden Anspruch, **dadurch gekennzeichnet, dass** die Grundkopplungs-Stromquelle (15) durch die Stromquelle (9) für die Sende-Lichtquelle (2) und einen ohmschen Stromteiler (19) mit einer Diode (24), bevorzugt mit einer Schottky-Diode, realisiert ist.

8. Messanordnung nach Anspruch 6, **dadurch gekennzeichnet, dass** die Grundkopplungs-Stromquelle (15) durch die Stromquelle (9) für die Sende-Lichtquelle (2) und einen ohmschen Stromteiler (19) mit wenigstens zwei Transistoren, bevorzugt mit wenigstens zwei MOSFET-Transistoren, realisiert ist.

9. Messanordnung nach einem der Ansprüche 1 bis 5, **dadurch gekennzeichnet, dass** die Grundkopplungs-Stromquelle (15) durch die Stromquelle (9) für die Sende-Lichtquelle (2) gebildet und der Grundkopplungs-Steuerstrom

durch den parametrisierten Sendesteuerstrom gebildet wird, wobei die Generierung des parametrisierten Grundkopplungs-Steuerstroms in einem Chip erfolgt.

10. Messanordnung nach dem Anspruch 9 **dadurch gekennzeichnet, dass** die Grundkopplungs-Stromquelle (15) proportional zur Stromquelle (9) von der Reglereinheit (12) mitgeregelt wird.

11. Messanordnung nach dem Anspruch 9 **dadurch gekennzeichnet, dass** die Stromamplitude der Grundkopplungs-Stromquelle (15a) für jede Stromquelle (9) fest eingestellt werden kann.

12. Messanordnung nach einem der vorhergehenden Ansprüche, **dadurch gekennzeichnet, dass** die Messanordnung (1) mehrere SendeLichtquellen (2) umfasst, die sequentiell nacheinander in je einer Regelschleife durch die Kompensationslichtquelle (3) kompensiert werden und für die jeweils ein Grundkopplungs-Steuerstrom erzeugt wird.

13. Messanordnung nach einem der vorhergehenden Ansprüche, **dadurch gekennzeichnet, dass** die Stromquellen (9, 10, 15), insbesondere die steuerbare Stromquelle (9) für die Sende-Lichtquelle (2) und die steuerbare Grundkopplungs-Stromquelle (15), von einem oder mehreren Signalgebern (16) gespeist werden, wobei der Signalgeber (16) bevorzugt in dem Chip integriert ist.

**Claims**

1. An opto-electronic measuring arrangement that is largely independent of extraneous light, comprising

- a transmission light source (2) and a compensation light source (3), which sequentially emit clocked phased light, wherein the light emitted by each is phase-shifted with respect to the other,
- an optical receiver (4) with a photodiode (5) for receiving light that contains a clock synchronous measurement signal transmitted by the light sources (2, 3), and with an amplifier unit (6) for amplifying a measurement signal current based on the received measurement signal,
- a clock generator (8) for generating a clock signal,
- a demodulator (11) for clock synchronous evaluation of the measurement signal current,
- a controllable current source (9) for generating a clocked transmission control current for the transmission light source (2),
- a controllable compensation current source (10) for generating a clocked compensation control current for the compensation light source (3), and
- a controller unit (12) for generating at least one control signal for the controllable current source (9) and/or compensation current source (10), wherein the controller unit (12) is designed such that the amplitude of the light intensity of the compensation light source (3) and/or the transmission light source (2) is controllable by controlling the compensation control current and/or the transmission control current in such manner that the clock synchronous signal difference arising between the different phases is reduced to zero,

**characterized by**

- a controllable basic coupling current source (15) for generating a clocked basic coupling control current,
- a basic coupling light source (17) that is different from the transmission light source (2) and is supplied with the basic coupling control current and transmits light directly to the optical receiver (4);
- the basic coupling control current being set in such manner that a desired sensitivity of the measurement arrangement (1) is achieved and/or a desired resting value of the controller unit (12) is adjustable,
- wherein in the absence of an object (13) to be detected the controller unit (12) controls the transmission light source (2) and/or the compensation light source (3) in such manner that the measurement signal received from the basic coupling current source (15) is adjusted,

wherein

- the controllable current source (9) for generating a clocked transmission control current and the controllable basic coupling current source (15) for generating a clocked basic coupling control current are clocked with the clock signal of the clock generator (8),
- the controllable compensation current source (10) for generating a clocked compensation control current is clocked with the inverted clock signal of the clock generator (8).

2. The measuring arrangement according to claim 1, **characterized in that** the basic coupling light source (17) supplied with the basic coupling control current is the compensation light source (3) and the measuring arrangement (1) comprises an adder (18) in which the basic coupling control current and the compensation control current are added together before they are fed to the compensation light source (3).

3. The measuring arrangement according to claim 1 or 2, **characterized in that** the transmission light source (2) is arranged in such manner that the basic coupling between the transmission light source (2) and the photodiode (5) constitutes not more than 50% of the functional optical object coupling generated by the transmission light source (2), preferably not more than 20%, 10%, 7%, 5%, 2%, 1%, or preferably practically zero, or no direct basic coupling exists.

4. The measuring arrangement according to any one of the preceding claims, **characterized in that** the basic coupling control current is set such that the electro-optical basic coupling of the compensation light source (3) is generated and/or changed.

5. The measuring arrangement according to any one of the preceding claims, **characterized in that** the transmission light source (2), the basic coupling light source (17) and/or the compensation light source (3) are each designed in the form of an LED.

6. The measuring arrangement according to any one of the preceding claims, **characterized in that** the basic coupling current source (15) is designed by the current source for generating a clocked transmission control current for the transmission light source (2), and a current splitter (19) is preferably provided in the form of Ohmic resistors (20, 21).

7. The measuring arrangement according to the preceding claim, **characterized in that** the basic coupling current source (15) is designed by the current source (9) for the transmission light source (2) and an Ohmic current splitter (19) with a diode (24), preferably a Schottky diode.

8. The measuring arrangement according to claim 6, **characterized in that** the basic coupling current source (15) is designed by the current source (9) for the transmission light source (2) and an Ohmic current splitter (19) having at least two transistors, preferably with at least two MOSFET transistors.

9. The measuring arrangement according to any one of claims 1 to 5, **characterized in that** the basic coupling current source (15) is formed by the current source (9) for the transmission light source (2) and the basic coupling control current is formed by the parameterized transmission control current, wherein the parameterized basic coupling control current is generated in a chip.

10. The measuring arrangement according to claim 9, **characterized in that** the basic coupling current source (15) is also adjusted by the controller unit (12) proportionally with the current source (9).

11. The measuring arrangement according to claim 9, **characterized in that** the current amplitude of the basic coupling current source (15a) can be set permanently for each current source (9).

12. The measuring arrangement according to any one of the preceding claims, **characterized in that** the measuring arrangement (1) comprises a plurality of transmission light sources (2), which are compensated by the compensation light source (3) sequentially one after the other in respective control loops and for each of which a basic coupling control current is generated.

13. The measuring arrangement according to any one of the preceding claims, **characterized in that** the current sources (9, 10, 15), particularly the controllable current source (9) for the transmission light source (2) and the controllable basic coupling current source (15) are supplied by one or more signal transmitters (16), wherein the signal transmitter (16) is preferably integrated in a chip.

**Revendications**

1. Dispositif de mesure optoélectronique insensible à la lumière parasite, comprenant

- une source lumineuse d'émission (2) et une source lumineuse de compensation (3) qui émettent de la lumière par phase, de manière séquentiellement cadencée, la lumière émise présentant à chaque fois un décalage de phase,

- un récepteur optique (4) avec une photodiode (5) pour recevoir de la lumière qui comprend un signal de mesure synchronisé avec la cadence émis par les sources lumineuses (2, 3), et avec une unité d'amplification (6) pour amplifier un courant de signal de mesure basé sur le signal de mesure,
- un générateur d'horloge (8) servant à générer un signal d'horloge,
- un démodulateur (11) servant à évaluer le courant de signal de mesure de manière synchronisée avec la cadence,
- une source de courant réglable (9) servant à générer un courant de commande d'émission cadencé pour la source lumineuse d'émission (2),
- une source de courant de compensation réglable (10) servant à générer un courant de commande de compensation cadencé pour la source lumineuse de compensation (3), et
- une unité de réglage (12) servant à générer au moins un signal de commande pour la source de courant réglable (9) et/ou la source de courant de compensation (10), l'unité de réglage (12) étant réalisée de telle sorte que l'amplitude de l'intensité lumineuse de la source lumineuse de compensation (3) et/ou de la source lumineuse d'émission (2) puisse être réglée par la commande du courant de commande de compensation et/ou courant de commande d'émission de manière que la différence de signal synchronisée avec la cadence se manifestant entre les différentes phases s'annule,

**caractérisé par**

- une source de courant de couplage de base (15) servant à générer un courant de commande de couplage de base,
- une source lumineuse de couplage de base (17) qui est différente de la source lumineuse d'émission (2) et alimentée avec le courant de commande de couplage de base et qui émet de la lumière directement vers le récepteur optique (4),
- le courant de commande de couplage de base étant réglé de manière à obtenir une sensibilité souhaitée du dispositif de mesure (1) et/ou à pouvoir régler une valeur de repos souhaitée de l'unité de réglage (12),
- sans la présence d'un objet à détecter (13), l'unité de réglage (12) réglant la source lumineuse d'émission (2) et/ou la source lumineuse de compensation (3) de manière que le signal de mesure reçu par la source lumineuse de couplage de base (15) soit réglé parfaitement,

sachant que

- la source de courant réglable (9) servant à générer un courant de commande d'émission cadencé et la source de courant de couplage de base réglable (15) servant à générer un courant de commande de couplage de base cadencé sont synchronisés avec le signal d'horloge du générateur d'horloge (8),
- la source de courant de compensation réglable (10) servant à générer un courant de commande de compensation cadencé est synchronisée avec le signal d'horloge inversé du générateur d'horloge (8).

2. Dispositif de mesure selon la revendication 1, **caractérisé en ce que** la source lumineuse de couplage de base (17) alimentée avec le courant de commande de couplage de base est la source lumineuse de compensation (3) et **en ce que** le dispositif de mesure (1) comprend un circuit additionneur (18) dans lequel le courant de commande de couplage de base et le courant de commande de compensation sont additionnés avant d'être amenés à la source lumineuse de compensation (3).

3. Dispositif de mesure selon la revendication 1 ou 2, **caractérisé en ce que** la source lumineuse d'émission (2) est disposée de telle manière que le couplage de base entre la source lumineuse d'émission (2) et la photodiode (5) ne dépasse pas 50% du couplage d'objet optique fonctionnel généré par la source lumineuse d'émission (2), de préférence ne dépasse pas 20%, 10%, 7%, 5%, 2%, 1% ou soit de préférence proche de zéro, ou qu'il n'y ait pas de couplage de base direct.

4. Dispositif de mesure selon l'une des revendications précédentes, **caractérisé en ce que** le courant de commande de couplage de base est réglé de manière à générer et/ou modifier le couplage de base électro-optique de la source lumineuse de compensation (3).

5. Dispositif de mesure selon l'une des revendications précédentes, **caractérisé en ce que** la source lumineuse d'émission (2) réalise la source lumineuse de couplage de base (17) et/ou la source lumineuse de compensation (3) avec à chaque fois une LED.

**6.** Dispositif de mesure selon l'une des revendications précédentes, **caractérisé en ce que** la source de courant de couplage de base (15) est réalisée par la source de courant générant un courant de commande d'émission cadencé pour la source lumineuse d'émission (2) et par un diviseur de courant (19), de préférence par des résistances ohmiques (20, 21).

**7.** Dispositif de mesure selon la revendication précédente, **caractérisé en ce que** la source de courant de couplage de base (15) est réalisée par la source de courant (9) pour la source lumineuse d'émission (2) et par un diviseur de courant ohmique (19) doté d'une diode (24), de préférence d'une diode de Schottky.

**8.** Dispositif de mesure selon la revendication 6, **caractérisé en ce que** la source de courant de couplage de base (15) est réalisée par la source de courant (9) pour la source lumineuse d'émission (2) et par un diviseur de courant ohmique (19) doté d'au moins deux transistors, de préférence d'au moins deux transistors MOSFET.

**9.** Dispositif de mesure selon l'une des revendications 1 à 5, **caractérisé en ce que** la source de courant de couplage de base (15) est formée par la source de courant (9) pour la source lumineuse d'émission (2) et **en ce que** le courant de commande de couplage de base est formé par le courant de commande d'émission paramétré, la génération du courant de commande d'émission paramétré ayant lieu dans une puce.

**10.** Dispositif de mesure selon la revendication 9, **caractérisé en ce que** la source de courant de couplage de base (15) est réglée par l'unité de réglage (12) proportionnellement à la source de courant (9) en même temps que celle-ci.

**11.** Dispositif de mesure selon la revendication 9, **caractérisé en ce que** l'amplitude du courant de la source de courant de couplage de base (15a) peut être fixée pour chaque source de courant (9).

**12.** Dispositif de mesure selon l'une des revendications précédentes, **caractérisé en ce que** le dispositif de mesure (1) comprend plusieurs sources lumineuses d'émission (2) qui sont compensées séquentiellement l'une après l'autre par la source lumineuse de compensation (3) dans une boucle d'asservissement respective et pour lesquelles est généré un courant de commande de couplage de base respectif.

**13.** Dispositif de mesure selon l'une des revendications précédentes, **caractérisé en ce que** les sources de courant (9, 10, 15), en particulier la source de courant réglable (9) pour la source lumineuse d'émission (2) et la source de courant de couplage de base réglable (15), sont alimentées par un ou plusieurs générateurs de signaux (16), le générateur de signaux (16) étant de préférence intégré dans une puce.

Fig. 1

Fig. 2

EP 2 598 908 B1

Fig. 3

Fig. 4

Fig. 5

EP 2 598 908 B1

Fig. 6a

EP 2 598 908 B1

Fig. 6b

Fig. 6c

EP 2 598 908 B1

Fig. 6d

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5666037 A
- EP 0706648 B1
- EP 1671160 B1
- DE 10001955 A1